(19) Europäisches Patentamt
European Patent Office
Office européen des brevets

(11) EP 0 812 062 B1

(12) EUROPEAN PATENT SPECIFICATION

(45) Date of publication and mention of the grant of the patent:
**04.12.2002 Bulletin 2002/49**

(51) Int Cl.7: **H03G 1/00**

(21) Application number: **97109133.5**

(22) Date of filing: **05.06.1997**

# (54) Gain-variable amplifier with wide control range

Verstärker mit variabler Verstärkung und grossem Steuerbereich

Amplificateur à gain variable avec une gamme de commande étendue

(84) Designated Contracting States:
**DE GB**

(30) Priority: **07.06.1996 JP 16839396**

(43) Date of publication of application:
**10.12.1997 Bulletin 1997/50**

(73) Proprietor: **NEC CORPORATION**
**Tokyo (JP)**

(72) Inventor: **Kagawa, Shigeru**
**Minato-ku, Tokyo (JP)**

(74) Representative: **Glawe, Delfs, Moll & Partner**
**Patentanwälte**
**Postfach 26 01 62**
**80058 München (DE)**

(56) References cited:
**WO-A-93/26090**

- **PATENT ABSTRACTS OF JAPAN vol. 008, no. 229 (E-273), 20 October 1984 -& JP 59 110211 A (NIPPON DENKI KK), 26 June 1984**
- **PATENT ABSTRACTS OF JAPAN vol. 006, no. 170 (E-128), 3 September 1982 -& JP 57 087219 A (SANYO ELECTRIC CO LTD;OTHERS: 01), 31 May 1982**
- **PATENT ABSTRACTS OF JAPAN vol. 018, no. 280 (E-1555), 27 May 1994 & JP 06 053766 A (SHARP CORP), 25 February 1994**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 812 062 B1

## Description

BACKGROUND OF THE INVENTION

Field of the Invention

The present invention relates to a gain-variable amplifier.

Description of the Related Art

A prior art gain-variable amplifier includes a dual differential amplifier circuit for amplifying an input voltage to generate an output voltage with a gain in accordance with first and second control voltages, and a control voltage generating circuit, for generating the first and second control voltages in accordance with a gain control voltage, a polarity of a difference between the first and second control voltages is changed, when the gain control voltage is within a control range. This will be explained later in detail.

In the prior art gain-variable amplifier, however, since the gain characteristics have an inflection point with respect to the gain control voltage, it is difficult to control the gain by the gain control voltage. Also, the phase of an output voltage is inverted at the inflection point. This substantially reduces a control range of gain by the gain control voltage.

The HA-2547 datasheet of Harris corp. 1990 describes a quadrant analog multiplier having a Gilbert cell multiplier as a core. JP 59 110211 shows a gain control circuit, whose gain is controlled over a wide range by a voltage. WO 93 26090 describes a control-gain amplifier having constant quiescent load current despite changing gains.

SUMMARY OF THE INVENTION

It is an object of the present invention to easily control a gain-variable amplifier by a gain control voltage.

Another object is to provide a gain-variable amplifier with no inversion of phase of an output voltage.

According to the present invention, in a gain-variable amplifier including a dual differential amplifier circuit for amplifying an input voltage to generate an output voltage with a gain in accordance with first and second control voltages, and a control voltage generating circuit, for generating the first and second control voltages in accordance with a gain control voltage, a polarity of a difference between the first and second control voltages is unchanged, when the gain control voltage is within a control range. Thus, no inflection point is generated in the gain characteristics.

BRIEF DESCRIPTION OF THE DRAWINGS

The present invention will be more clearly understood from the description as set forth below, as compared with the prior art, with reference to the accompanying drawings, wherein:

Fig. 1 is a circuit diagram illustrating a prior art gain-variable amplifier;
Fig. 2 is a graph showing the gain characteristics of the gain-variable amplifier of Fig. 1;
Fig. 3 is a circuit diagram illustrating a first embodiment of the gain-variable amplifier according to the present invention;
Fig. 4 is a graph showing the gain characteristics of the gain-variable amplifier of Fig. 3;
Fig. 5 is a circuit diagram illustrating a second embodiment of the gain-variable amplifier according to the present invention;
Fig. 6 is a graph showing the gain characteristics of the gain-variable amplifier of Fig. 5;
Fig. 7 is a circuit diagram illustrating a third embodiment of the gain-variable amplifier according to the present invention; and
Fig. 8 is a circuit diagram illustrating a fourth embodiment of the gain-variable amplifier according to the present invention.

DESCRIPTION OF THE PREFERRED EMBODIMENTS

Before the description of the preferred embodiments, a prior art gain-variable amplifier will be explained with reference to Figs. 1 and 2.

In Fig. 1, a first differential amplifier is formed by two NPN type transistors $Q_1$ and $Q_2$ having a common emitter connected via a constant current source $IS_1$ whose current is $I_1$ to a ground terminal GND. An AC input voltage $V_{in}$ is applied between input terminals $IN_1$ and $IN_2$, i.e., between the bases of the transistors $Q_1$ and $Q_2$.

The first differential amplifier amplifies the input voltage $V_{in}$.

Also, a second differential amplifier is formed by two NPN type transistors $Q_3$ and $Q_4$ having a common emitter connected to the collector of the transistor $Q_1$. The collector of the transistor $Q_3$ is connected to a power supply terminal $V_{cc}$, while the collector of the transistor $Q_4$ is connected via an output resistor $R_0$ to the power supply terminal $V_{cc}$.

Similarly, a third differential amplifier is formed by two NPN type transistors $Q_5$ and $Q_6$ having a common emitter connected to the collector of the transistor $Q_2$. The collector of the transistor $Q_5$ is connected to the power supply terminal $V_{cc}$, while the collector of the transistor $Q_6$ is connected via the output resistor $R_0$ to the power supply terminal $V_{cc}$.

The output resistor $R_0$ provides an output voltage $V_{out}$ at an output terminal OUT. In this case, a current $I_0$ flowing through the resistor $R_0$ is formed by a negative phase current $I_-$ flowing through the transistor $Q_4$ of the second differential amplifier and the transistor $Q_1$ of the first differential amplifier and a positive phase current $I_-$ flowing through the transistor $Q_6$ of the third differential amplifier and the transistor $Q_2$ of the first differential amplifier. Note that the negative phase current $I_-$ is opposite in phase to the positive phase current $I_+$.

Also, the bases of the transistors $Q_3$ and $Q_6$ receive a first control voltage $V_{c1}$, while the bases of the transistors $Q_4$ and $Q_5$ receive a second control voltage $V_{c2}$. The control voltages $V_{c1}$ and $V_{c2}$ are generated by a control voltage generating circuit GEN.

The control voltages generating circuit GEN is constructed by a constant voltage source $VS_1$ and a voltage divider formed by two resistors $R_1$ and $R_2$ between the base of the transistor $Q_6$ and a gain control terminal C whose voltage is $V_c$. That is the control voltage $V_{c1}$ is generated by the constant voltage source $VS_1$, while the control voltage $V_{c2}$ is generated by the voltage divider ($R_1$, $R_2$). In this case,

$$V_{c2} = V_{c1} + (V_c - V_{c1}) \cdot R_1/(R_1 + R_2) \qquad (1)$$

Thus, the higher the voltage $V_{c2}(V_c)$, the larger the negative phase current $I_-$. On the other hand, the lower the voltage $V_{c2}(V_c)$, the larger the positive phase current $I_-$.

The operation of the gain-variable amplifier of Fig. 1 is explained next in more detail.

If $V_c>V_{c1}$, i.e., $V_{c2}>V_{c1}$, the voltage at the bases of the transistors $Q_3$ and $Q_6$ is higher than the voltage at the bases of the transistors $Q_4$ and $Q_5$. Therefore, the negative phase current $I_-$ is greater than the positive phase current $I_+$. In this state, when the gain control voltage $V_c$ is further increased, the current $I_0$ (= $I_+$ + $I_-$) is increased. Thus, as shown in Fig. 2, the gain of the gain-variable amplifier of Fig. 1 is increased as the gain control voltage $V_c$ is increased.

On the other hand, if $V_c<V_{c1}$, i.e., $V_{c2}<V_{c1}$, the voltage at the bases of the transistors $Q_4$ and $Q_5$ is higher than the voltage at the bases of the transistors $Q_3$ and $Q_6$. Therefore, the positive phase current $I_+$ is greater than the negative phase current $I_-$. In this state, when the again control voltage $V_c$ is further decreased, the current $I_0$ (= $I_+$ + $I_-$) is increased. Thus, as shown in Fig. 2, the gain of the gain-variable amplifier of Fig. 1 is increased as the gain control voltage $V_c$ is decreased.

In addition, if $V_c = V_{c1}$, i.e., $V_{c2} = V_{c1}$, the voltage at the bases of the transistors $Q_3$ and $Q_6$ is equal to the voltage at the bases of the transistors $Q_4$ and $Q_5$. Therefore, the negative phase current $I_-$ is equal to the positive phase current $I_+$. In this case, since the negative phase current $I_-$ is opposite in phase to the positive phase current $I_+$, so that the negative phase current $I_-$ offsets the positive phase current $I_+$, the current $I_0$ includes only a DC component and is minimum. Thus, as shown in Fig. 2, the gain of the gain-variable amplifier of Fig. 1 is minimum.

In the gain-variable amplifier of Fig. 1, since the gain characteristics has an inflection point as indicated by A in Fig. 2, it is difficult to control the gain by the gain control voltage $V_c$. Also, the phase of the output voltage $V_{out}$ is inverted at the inflection point A. Since only a half of the exploitable control range is utilized, the control range is substantially reduced.

In Fig. 3, which illustrates a first embodiment of the present invention, a control voltage generating circuit GEN1 is provided instead of the control voltage generating circuit GEN. The control voltage generating circuit GEN1 is constructed by a differential amplifier formed by NPN type transistors $Q_{11}$ and $Q_{12}$ having a common emitter connected to a constant current source $IS_2$ whose current is $I_2$. The base of the transistor $Q_{11}$ is connected to a constant voltage source $VS_2$ whose voltage is $V_R$, and a voltage divider formed by resistors $R_{11}$ and $R_{12}$ is connected between the base of the transistor $Q_{11}$ and the gain control terminal C.

Also, a resistor $R_{13}$ is connected between the power supply terminal $V_{cc}$ and the collector of the transistor $Q_{11}$, and resistors $R_{14}$ and $R_{15}$ are connected between the power supply terminal $V_{cc}$ and the collector of the transistor $Q_{12}$. Further, a resistor $R_{16}$ is connected between the collectors of the transistors $Q_{11}$ and $Q_{12}$. Here, assume that

$$R_{13} = R_{14} \qquad (2)$$

$$R_{15} = R_{16} \quad (3)$$

The operation of the gain variable amplifier of Fig. 3 is explained next.

If $V_c$ = 0V (GND), the voltage at the base of the transistor $Q_{11}$ is higher than the voltage at the base of the transistor $Q_{12}$, so that the transistors $Q_{11}$ and $Q_{12}$ are turned ON and OFF, respectively. As a result, the current $I_2$ flows through the transistor $Q_{11}$. In this case,

$$V_{c2} = V_{c1}$$

$$+ (V_{cc} - V_{c1}) \cdot (R_{15} + R_{16}) / (R_{14} + R_{15} + R_{16}) > V_{c1} \quad (4)$$

Thus, the negative phase current $I_-$ is greater than the positive phase current $I_+$.

Also, if $V_c = V_R$, the voltage at the base of the transistor $Q_{11}$ is equal to the voltage at the base of the transistor $Q_{12}$. As a result, a current of $I_2/2$ flows through each of the transistors $Q_{11}$ and $Q_{12}$. Therefore, if a current flowing from the collector of the transistor $Q_{1\ 1}$ via the resistor $R_{16}$ to the collector of the transistor $Q_{12}$ is defined by $I_{16}$,

$$V_{c1} = V_{cc} - (I_2/2 + I_{16}) \cdot R_{13} \quad (5)$$

$$V_{c2} = V_{cc} - (I_2/2 - I_{16}) \cdot R_{14} \quad (6)$$

Since $R_{13} = R_{14}$ (see formula (2)), from the formulae (5) and (6),

$$V_{c2} > V_{c1} \quad (7)$$

Further, if $V_c = V_{cc}$, the voltage at the base of the transistor $Q_{11}$ is lower than the voltage at the base of the transistor $Q_{12}$, so that the transistors $Q_{11}$ and $Q_{12}$ are turned OFF and ON, respectively. As a result, the current $I_2$ flows through the transistor $Q_{12}$. Also, in this case, from the formulae (2) and (3),

$$R_{13} + R_{16} = R_{14} + R_{15} \quad (8)$$

Therefore, a current of $I_2/2$ flows through the resistors $R_{13}$ and $R_{16}$, and also, a current of $I_2/2$ flows through the resistors $R_{14}$ and $R_{15}$. Therefore,

$$V_{c1} = V_{cc} - (I_2/2) \cdot R_{13} \quad (9)$$

$$V_{c2} = V_{cc} - (I_2/2) \cdot R_{14} \quad (10)$$

Since $R_{13} = R_{14}$ (see formula (2)), from the formulae (9) and (10),

$$V_{c2} = V_{c1} \quad (11)$$

Therefore, as shown in Fig. 4, the gain of the gain-variable amplifier of Fig. 3 is decreased as the gain control voltage $V_c$ is increased. In this case, since the gain control voltage $V_c$ is from OV to $V_{cc}$, the negative phase current $I_-$ is greater than the positive phase current $I_-$, Also, when $V_c = V_{cc}$, the gain of the gain-variable amplifier of Fig. 3 is minimum as indicated by A in Fig. 4.

Thus, in the gain-variable amplifier of Fig. 3, since the gain characteristics have no inflection point, it is easy to control the gain by the gain control voltage $V_c$. Also, the phase of the output voltage $V_{out}$ is never inverted. Since a full of the exploitable control range can be utilized, the control range of gain by the gain control voltage $V_c$ can be substantially increased.

In Fig. 5, which illustrates a second embodiment of the present invention, a control voltage generating circuit GEN2 is provided instead of the control voltage generating circuit GEN1 of Fig. 3. In the control voltage generating circuit GEN2, the resistor $R_{13}$ of Fig. 3 is exchanged with the resistors $R_{14}$ and $R_{15}$ of Fig. 3. In other words, the control voltages $V_{c1}$ and $V_{c2}$ are exchanged with each other.

The operation of the gain variable amplifier of Fig. 5 is explained next.

If $V_c$ = OV(GND), the voltage at the base of the transistor $Q_{11}$ is higher than the voltage at the base of the transistor $Q_{12}$, so that the transistors $Q_{11}$ and $Q_{12}$ are turned ON and OFF, respectively. As a result, the current $I_2$ flows through the transistor $Q_{11}$. Also, in this case, from the formula (8), a current of $I_2/2$ flows through the resistors $R_{13}$ and $R_{16}$, and also, a current of $I_2/2$ flows through the resistors $R_{14}$ and $R_{15}$. Therefore,

$$V_{c1} = V_{cc} - I_2/2) \cdot R_{13} \quad (12)$$

$$V_{c2} = V_{cc} - (I_2/2) \cdot R_{14} \quad (13)$$

Since $R_{13} = R_{14}$ (see formula (2)), from the formulae (12) and (13),

$$V_{c2} = V_{c1} \quad (14)$$

Also, if $V_c = V_R$, the voltage at the base of the transistor $Q_{11}$ is equal to the voltage at the base of the transistor $Q_{12}$. As a result, a current of $I_2/2$ flows through each of the transistors $Q_{11}$ and $Q_{12}$. Therefore,

$$V_{c1} = V_{cc} - (I_2/2 - I_{16}) \cdot R_{13} \quad (15)$$

$$V_{c2} = V_{cc} - (I_2/2 + I_{16}) \cdot R_{14} \quad (16)$$

Since $R_{13} = R_{14}$ (see formula (2)), from the formulae (15) and (16),

$$V_{c2} < V_{c1} \quad (17)$$

Further, if $V_c = V_{cc}$, the voltage at the base of the transistor $Q_{11}$ is lower than the voltage at the base of the transistor $Q_{12}$, so that the transistors $Q_{11}$ and $Q_{12}$ are turned OFF and ON, respectively. As a result, the current $I_2$ flows through the transistor $Q_{12}$. In this case,

$$V_{c1} = V_{c2} + (V_{cc} - V_{c2}) \cdot (R_{15} + R_{16}) / (R_{14} + R_{15} + R_{16}) > V_{c2} \quad (18)$$

Thus, the positive phase current $I_+$ is greater than the negative phase current $I_-$.

Therefore, as shown in Fig. 6, the gain of the gain-variable amplifier of Fig. 5 is increased as the gain control voltage $V_c$ is increased. In this case, the gain control voltage $V_c$ is from OV to $V_{cc}$, the positive phase current $I_+$ is greater than the negative phase current $I_-$ . Also, when $V_c$ = OV, the gain of the gain-variable amplifier of Fig. 5 is minimum as indicated by A in Fig. 6.

Thus, in the gain-variable amplifier of Fig. 5, since the gain characteristics have no inflection point, it is easy to control the gain by the gain control voltage $V_c$. Also, the phase of the output voltage $V_{out}$ is never inverted. Since a full of the exploitable control range can be utilized, the control range of gain by the gain control voltage $V_c$ can be substantially increased.

In Fig. 7, which illustrates a third embodiment of the present invention, the resistors $R_{13}$, $R_{14}$, $R_{15}$ and $R_{16}$ of Fig. 3 are replaced by diodes $D_1$, $D_2$, $D_3$ and $D_4$, respectively. In this case, the values of the resistors $R_{13}$, $R_{14}$, $R_{15}$ and $R_{16}$ of Fig. 3 are replaced by the saturation currents of the diodes $D_1$, $D_2$, $D_3$ and $D_4$, respectively. That is, the saturation current of the diode $D_1$ is equal to that of the diode $D_2$, and the saturation current of the diode $D_3$ is equal to that of the diode $D_4$. Thus, the operation of the gain-variable amplifier of Fig. 7 is the same as that of the gain-variable amplifier of Fig. 3.

In Fig. 8, which illustrates a fourth embodiment of the present invention, the resistors $R_{13}$, $R_{14}$, $R_{15}$ and $R_{16}$ of Fig. 5 are replaced by diodes $D_1$, $D_2$, $D_3$ and $D_4$, respectively. Also, in this case, the values of the resistors $R_{13}$, $R_{14}$, $R_{15}$ and $R_{16}$ of Fig. 5 are replaced by the saturation currents of the diodes $D_1$, $D_2$, $D_3$ and $D_4$, respectively. That is, the saturation current of the diode $D_1$ is equal to that of the diode $D_2$, and the saturation current of the diode $D_3$ is equal to that of the diode $D_4$. Thus, the operation of the gain-variable amplifier of Fig. 8 is the same as that of the gain-variable amplifier of Fig. 5.

As explained hereinabove, according to the present invention, since the gain characteristics have no inflection point, it is easy to control the gain by the gain control voltage. Also, the phase of the output voltage is never inverted. As a result, a control range of gain by the gain control voltage can be substantially increased.

## Claims

**1.** A gain-variable amplifier comprising:

first and second power supply terminals (GND, Vcc);
a Gilbert cell multiplier including
a first differential pair (Q1, Q2) having differential inputs coupled to two input terminals (IN1, IN2) for accepting an input signal;
second and third crosscoupled differential pairs (Q3-4, Q5-6), one output of which is connected to an output terminal (OUT) and connected through a resistor (Ro) to said second power supply terminal, and the two inputs of which are connected to two circuit nodes providing first and second control signals (Vc1, Vc2);
a control voltage generating circuit (GEN1, GEN2) for generating said first and second control voltages in accordance with a gain control voltage (Vc), so that a polarity of the difference between said first and second control voltages is unchanged when said gain control voltage is changed between a voltage at said first power supply terminal and a voltage at said second power supply terminal, **characterized in that** said control voltage generating circuit comprises:

a differential amplifier formed by first and second transistors (Q11, Q12) connected via a constant current source (IS2) to said first power supply terminal, the input of one of said first and second transistors connected to a reference voltage input (VR), the input of the other one of said first and second transistors coupled to an input terminal (C) for receiving said gain control-voltage (Vc), one of the two outputs of said differential amplifier being connected to.said second power supply terminal through a first circuit element (R13, D1), the other one of the two outputs of said differential amplifier being connected to said second power supply terminal through second and third series coupled circuit elemehts (R14-15, D2-3), the two outputs of said differential amplifier being interconnected through a fourth circuit element (R16, D4), the circuit node defined by said first and fourth circuit elements providing one of said first and second control signals (Vc1, Vc2), the circuit node defined by said second and third circuit elements providing the other one of said first and second control signals (Vc1, Vc2), and wherein said first to fourth circuit elements are all resistors or are all diodes.

**2.** The gain-variable amplifier of claim 1, wherein
said first and second transistors (Q11, Q12) of said differential amplifier respectively receive said reference (Vr) and gain control (Vc) voltages at their bases,
said first to fourth circuit elements are first to fourth resistors (R13-16), and
said one of the two outputs of said differential amplifier is associated with said first transistor (Q11) of said differential amplifier, and
said other one of the two outputs of said differential amplifier is associated with said second transistor (Q12) of said differential amplifier.

**3.** The gain-variable amplifier of claim 1, wherein
said first and second transistors (Q11, Q12) of said differential amplifier respectively receive said reference (Vr) and gain control (Vc) voltages at their bases,
said first to fourth circuit elements are first to fourth resistors (R13-16), and
said one of the two outputs of said differential amplifier is associated with said second transistor (Q12) of said differential amplifier, and
said other one of the two outputs of said differential amplifier is associated with said first transistor (Q11) of said differential amplifier.

4. The variable-gain amplifier as set forth in claim 2 or 3, wherein a resistance value of said first resistor is equal to a resistance value of said second resistor,
a resistance value of said third resistor being equal to a resistance value of said fourth resistor.

5. The gain-variable amplifier of claim 1, wherein
said first and second transistors (Q11, Q12) of said differential amplifier respectively receive said reference (Vr) and gain control (Vc) voltages at their bases,
said first to fourth circuit elements are first to fourth diodes (D1-4), and
said one of the two outputs of said differential amplifier is associated with said first transistor (Q11) of said differential amplifier, and
said other one of the two outputs of said differential amplifier is associated with said second transistor (Q12) of said differential amplifier.

6. The gain-variable amplifier of claim 1, wherein
said first and second transistors (Q11, Q12) of said differential amplifier respectively receive said reference (Vr) and gain control (Vc) voltages at their bases,
said first to fourth circuit elements are first to fourth diodes (D1-4), and
said one of the two outputs of said differential amplifier is associated with said second transistor (Q12) of said differential amplifier, and
said other one of the two outputs of said differential amplifier is associated with said first transistor (Q11) of said differential amplifier.

7. The variable-gain amplifier as set forth in claim 5 or 6, wherein a saturation current value of said first diode is equal to a saturation current value of said second diode,
a saturation current value of said third diode being equal to a saturation current value of said fourth diode.

## Patentansprüche

1. Verstärker mit variabler Verstärkung mit:

einem ersten und einem zweiten Stromzufuhranschluss (GND, Vcc);
einem Gilbertzellenmultiplikator, der ein erstes Differenzpaar (Q1, Q2) mit Differenzeingängen enthält, die an zwei Eingangsanschlüsse [IN1, IN2]zum Aufnehmen eines Eingangssignales gekoppelt sind;
einem zweiten und einem dritten kreuzgekoppelten Differenzpaar (Q3-4, Q5-6), dessen einer Ausgang mit einem Ausgabeanschluß (OUT) verbunden und über einen Widerstand (Ro) mit dem zweiten Stromzufuhranschluß verbunden ist und dessen zwei Eingänge mit zwei Schaltknoten verbunden sind, die erste und zweite Steuersignale (Vc1, Vc2) bereitstellen liefern;
einer Steuerspannungserzeugungsschaltung (GEN1, GEN2) zum Erzeugen der ersten und zweiten Steuerspannungen in Übereinstimmung mit einer Verstärkungssteuerspannung (Vc), so daß ein Phasenunterschied zwischen der ersten und zweiten Steuerspannung nicht verändert wird, wenn die Verstärkungssteuerspannung zwischen einer Spannung an dem ersten Stromzufuhranschluß und einer Spannung an dem zweiten Stromzufuhranschluß verändert wird,

**dadurch gekennzeichnet, daß** die Steuerspannungserzeugungsschaltung aufweist:

einen Differenzverstärker, der aus ersten und zweiten Transistoren (Q11, Q12) gebildet ist, die über eine Konstantstromquelle (IS2) mit dem ersten Stromzufuhranschluß verbunden sind, wobei der Eingang von dem ersten oder dem zweiten Transistor mit dem Bezugsspannungseingang (VR) verbunden ist, der Eingang des anderen von dem ersten und dem zweiten Transistor an einen Eingangsanschluß (C) zum Empfangen der Verstärkungssteuersspannung (Vc) gekoppelt ist, wobei einer der beiden Ausgänge des Differenzverstärkers mit dem zweiten Stromzufuhranschluß über ein erstes Schaltungsbauteil (R13, D1) verbunden ist und der andere der zwei Ausgänge des Differenzverstärkers mit dem zweiten Stromzufuhranschluß über ein zweites und ein drittes Schaltungsbauteil (R14-15, D2-3) in Reihenschaltung verbunden ist, wobei die zwei Ausgänge des Differenzverstärkers miteinander über ein viertes Schaltungselement (R16, D4) miteinander verbunden sind, wobei der Schaltknoten, der durch das erste und das vierte Schaltungsbauteil bestimmt ist, eins der ersten und zweiten Steuersignale (Vc1, Vc2) liefert, wobei der Schaltknoten, der durch das zweite und das dritte Schaltungsbauteil bestimmt ist, das andere von dem ersten und zweiten Steuersignal (Vc1, Vc2) liefert, und wobei die ersten bis vierten Schaltungsbauteile alle Widerstände oder alle Dioden sind.

**2.** Verstärker mit variabler Verstärkung nach Anspruch 1,
wobei der erste und der zweite Transistor (Q11, Q12) des Differenzverstärkers die Bezugsspannung (Vr) bzw. die Verstärkungssteuerspannung (Vc) an ihren Basen empfangen, die ersten bis vierten Schaltungsbauteile erste bis vierte Widerstände (R13-16) sind, von den zwei Ausgängen des Differenzverstärkers der eine mit dem ersten Transistor (Q11) des Differenzverstärkers verbunden ist und von den zwei Ausgängen des Differenzverstärkers der andere mit dem zweiten Transistor (Q12) des Differenzverstärkers verbunden ist.

**3.** Verstärker mit variabler Verstärkung nach Anspruch 1,
wobei der erste und der zweite Transistor (Q11, Q12) des Differenzverstärkers die Bezugsspannung (Vr) bzw. die Verstärkungssteuerspannung (Vc) an ihren Basen empfangen, die ersten bis vierten Schaltungsbauteile erste bis vierte Widerstände (R13-16) sind, von den zwei Ausgängen des Differenzverstärkers der eine mit dem zweiten Transistor (Q12) des Differenzverstärkers verbunden ist und von den zwei Ausgängen des Differenzverstärkers der andere mit dem ersten Transistor (Q11) des Differenzverstärkers verbunden ist.

**4.** Verstärker mit variabler Verstärkung nach Anspruch 2 oder 3,
wobei ein Widerstandswert des ersten Widerstandes gleich einem Widerstandswert des zweiten Widerstandes ist und ein Widerstandswert des dritten Widerstandes gleich einem Widerstandswert des vierten Widerstandes ist.

**5.** Verstärker mit variabler Verstärkung nach Anspruch 1,
wobei der erste und der zweite Transistor (Q11, Q12) des Differenzverstärkers die Bezugsspannung (Vr) bzw. die Verstärkungssteuerspannung (Vc) an ihren Basen empfangen, die ersten bis vierten Schaltungsbauteile erste bis vierte Dioden (D1-4) sind, von den beiden Ausgängen des Differenzverstärkers der eine mit dem ersten Transistor (Q11) des Differenzverstärkers verbunden ist und von den beiden Ausgängen des Differenzverstärkers der andere mit dem zweiten Transistor (Q12) des Differenzverstärkers verbunden ist.

**6.** Verstärker mit variabler Verstärkung nach Anspruch 1,
wobei der erste und der zweite Transistor (Q11, Q12) des Differenzverstärkers die Bezugsspannung (Vr) und die Verstärkungssteuerspannung (Vc) an ihren Basen empfangen, die ersten bis vierten Schaltungsbauteile erste bis vierte Dioden (D1-4) sind, von den zwei Ausgängen des Differenzverstärkers der eine mit dem zweiten Transistor (Q12) des Differenzverstärkers verbunden ist und von den zwei Ausgängen des Differenzverstärkers der andere mit dem ersten Transistor (Q11) des Differenzverstärkers verbunden ist.

**7.** Verstärker mit variabler Verstärkung nach Anspruch 5 oder 6,
wobei ein Sättigungsstromwert der ersten Diode gleich einem Sättigungsstromwert der zweiten Diode ist und ein Sättigungsstromwert der dritten Diode gleich einem Sättigungsstromwert der vierten Diode ist.

## Revendications

**1.** Amplificateur à gain variable comprenant :

des première et seconde bornes d'alimentation (GND, Vcc),
un multiplicateur à cellule de Gilbert comprenant
une première paire différentielle (Q1, Q2) comportant des entrées différentielles reliées à deux bornes d'entrée (IN1, IN2) afin de recevoir un signal d'entrée,
des seconde et troisième paires différentielles couplées transversalement (Q3-4, Q5-6), dont une sortie est reliée à une borne de sortie (OUT) et reliées par l'intermédiaire d'une résistance (Ro) à ladite seconde borne d'alimentation, et dont les deux entrées sont reliées à deux noeuds de circuit fournissant des premier et second signaux de commande (Vc1, Vc2),
un circuit de génération de tension de commande (GEN1, GEN2) destiné à générer lesdites première et seconde tensions de commande conformément à une tension de commande de gain (Vc), de sorte qu'une polarité de la différence entre lesdites première et seconde tensions de commande est inchangée lorsque ladite tension de commande de gain est changée entre une tension à ladite première borne d'alimentation et une tension à ladite seconde borne d'alimentation, **caractérisé en ce que** ledit circuit de génération de tension de commande comprend :

un amplificateur différentiel constitué d'un premier et d'un second transistors (Q11, Q12) reliés par l'intermédiaire d'une source de courant constant (IS2) à ladite première borne d'alimentation, l'entrée de l'un desdits premier et second transistors étant reliée à une entrée de tension de référence (VR), l'entrée de l'autre desdits premier et second transistors étant reliée à une borne d'entrée (C) afin de recevoir ladite tension de commande de gain (Vc), l'une des deux sorties dudit amplificateur différentiel étant reliée à ladite seconde borne d'alimentation par l'intermédiaire d'un premier élément de circuit (R13, D1), l'autre des deux sorties dudit amplificateur différentiel étant reliée à ladite seconde borne d'alimentation par l'intermédiaire des second et troisième éléments de circuit reliés en série (R14-15, D2-3), les deux sorties dudit amplificateur différentiel étant interconnectées par l'intermédiaire d'un quatrième élément de circuit (R16, D4), le noeud de circuit défini par lesdits premier et quatrième éléments de circuit fournissant l'un desdits premier et second signaux de commande (Vc1, Vc2), le noeud de circuit défini par lesdits second et troisième éléments de circuit fournissant l'autre desdits premier et second signaux de commande (Vc1, Vc2), et dans lequel lesdits premier à quatrième éléments de circuit sont tous des résistances ou sont tous des diodes.

**2.** Amplificateur à gain variable selon la revendication 1, dans lequel
lesdits premier et second transistors (Q11, Q12) dudit amplificateur différentiel reçoivent respectivement lesdites tensions de référence (Vr) et de commande de gain (Vc) à leurs bases,
lesdits premier à quatrième éléments de circuit sont des première à quatrième résistances (R13-16), et ladite l'une des deux sorties dudit amplificateur différentiel est associée audit premier transistor (Q11) dudit amplificateur différentiel, et
ladite l'autre des deux sorties dudit amplificateur différentiel est associée audit second transistor (Q12) dudit amplificateur différentiel.

**3.** Amplificateur à gain variable selon la revendication 1, dans lequel
lesdits premier et second transistors (Q11, Q12) dudit amplificateur différentiel reçoivent respectivement lesdites tensions de référence (Vr) et de commande de gain (Vc) à leurs bases,
lesdits premier à quatrième éléments de circuit sont des première à quatrième résistances (R13-16), et ladite l'une des deux sorties dudit amplificateur différentiel est associée audit second transistor (Q12) dudit amplificateur différentiel, et
ladite l'autre des deux sorties dudit amplificateur différentiel est associée audit premier transistor (Q11) dudit amplificateur différentiel.

**4.** Amplificateur à gain variable selon la revendication 2 ou 3, dans lequel une valeur ohmique de ladite première résistance est égale à une valeur ohmique de ladite seconde résistance,
une valeur ohmique de ladite troisième résistance étant égale à une valeur ohmique de ladite quatrième résistance.

**5.** Amplificateur à gain variable selon la revendication 1, dans lequel
lesdits premier et second transistors (Q11, Q12) dudit amplificateur différentiel reçoivent respectivement lesdites tensions de référence (Vr) et de commande de gain (Vc) à leurs bases,
lesdits premier à quatrième éléments de circuit sont des première à quatrième diodes (D1-4 et ladite l'une des deux sorties dudit amplificateur différentiel est associée audit premier transistor (Q11) dudit amplificateur différentiel, et
ladite l'autre des deux sorties dudit amplificateur différentiel est associée audit second transistor (Q12) dudit amplificateur différentiel.

**6.** Amplificateur à gain variable selon la revendication 1, dans lequel
lesdits premier et second transistors (Q11, Q12) dudit amplificateur différentiel reçoivent respectivement lesdites tensions de référence (Vr) et de commande de gain (Vc) à leurs bases,
lesdits premier à quatrième éléments de circuit sont des première à quatrième diodes (D1-4), et ladite l'une des deux sorties dudit amplificateur différentiel est associée audit second transistor (Q12) dudit amplificateur différentiel, et
ladite l'autre des deux sorties dudit amplificateur différentiel est associée audit premier transistor (Q11) dudit amplificateur différentiel.

7. Amplificateur à gain variable selon la revendication 5 ou 6, dans lequel une valeur de courant de saturation de ladite première diode est égale à une valeur de courant de saturation de ladite seconde diode,

une valeur de courant de saturation de ladite troisième diode étant égale à une valeur de courant de saturation de ladite quatrième diode.

Fig. 1

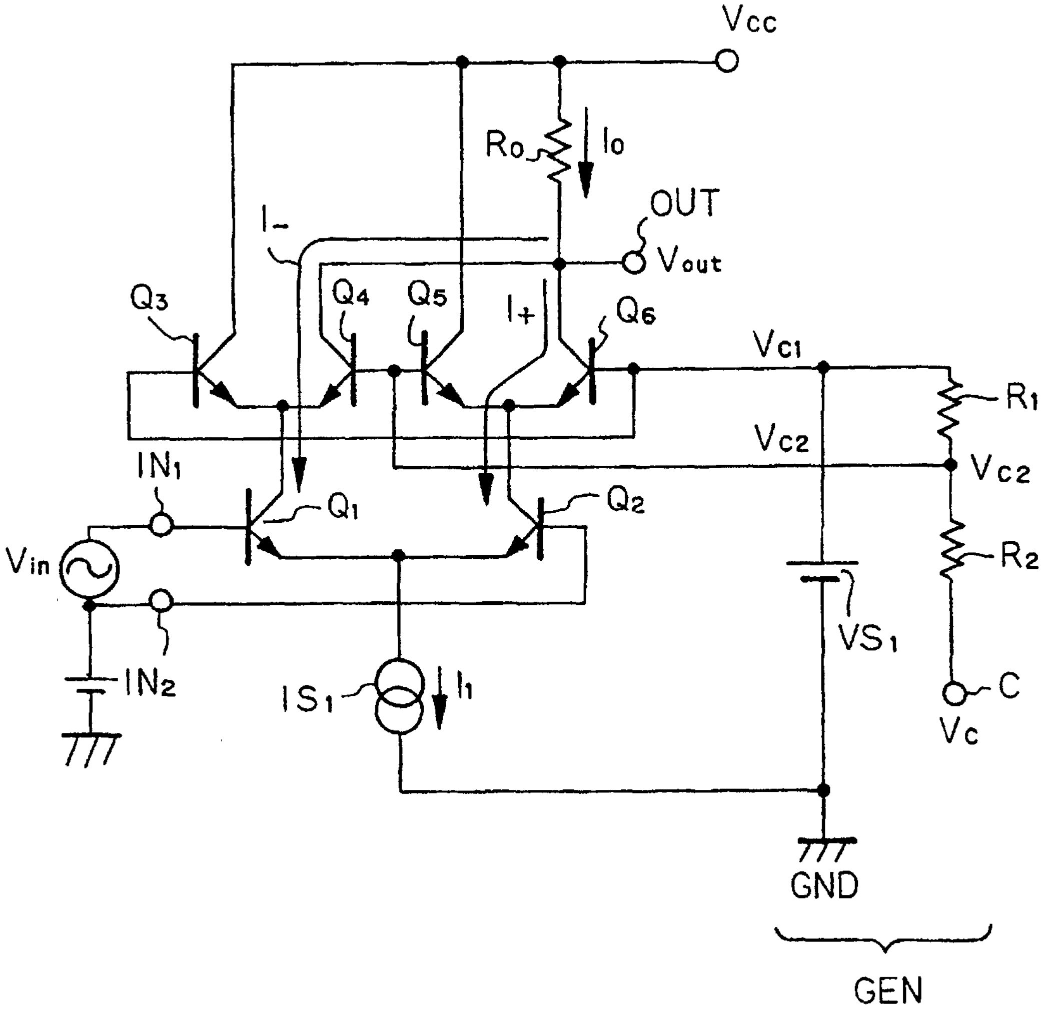
Vcc
Ro
Io
OUT
Vout
I-
I+
Q3
Q4
Q5
Q6
Vc1
R1
Vc2
Vc2
IN1
Q1
Q2
Vin
R2
IN2
VS1
IS1
I1
C
Vc
GND
GEN

*Fig. 2*

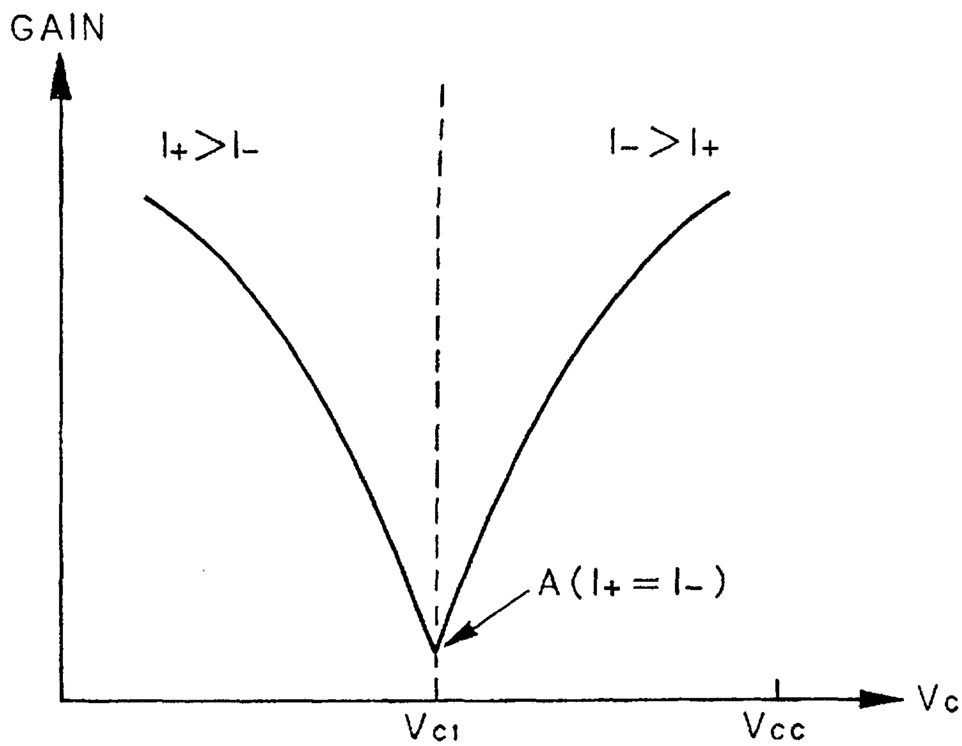

Fig. 3

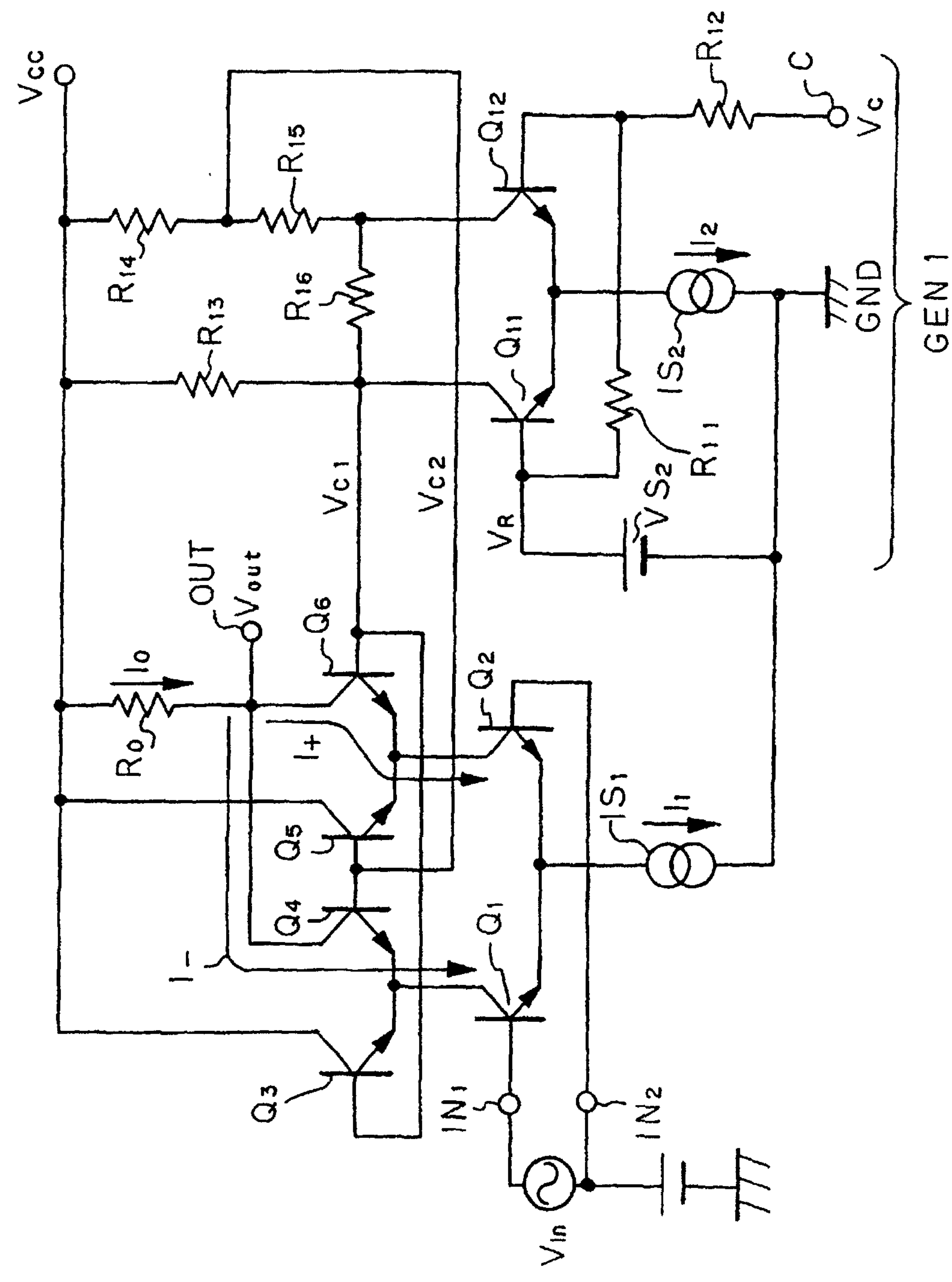
Vcc
R14
R15
R16
R13
Q12
Q11
R12
C
Vc
I2
IS2
R11
VS2
VR
GND
GEN 1
Vc1
Vc2
OUT
Vout
Q6
I0
R0
I+
Q2
Q5
IS1
I1
Q4
Q1
I−
Q3
IN1
IN2
Vin

*Fig. 4*

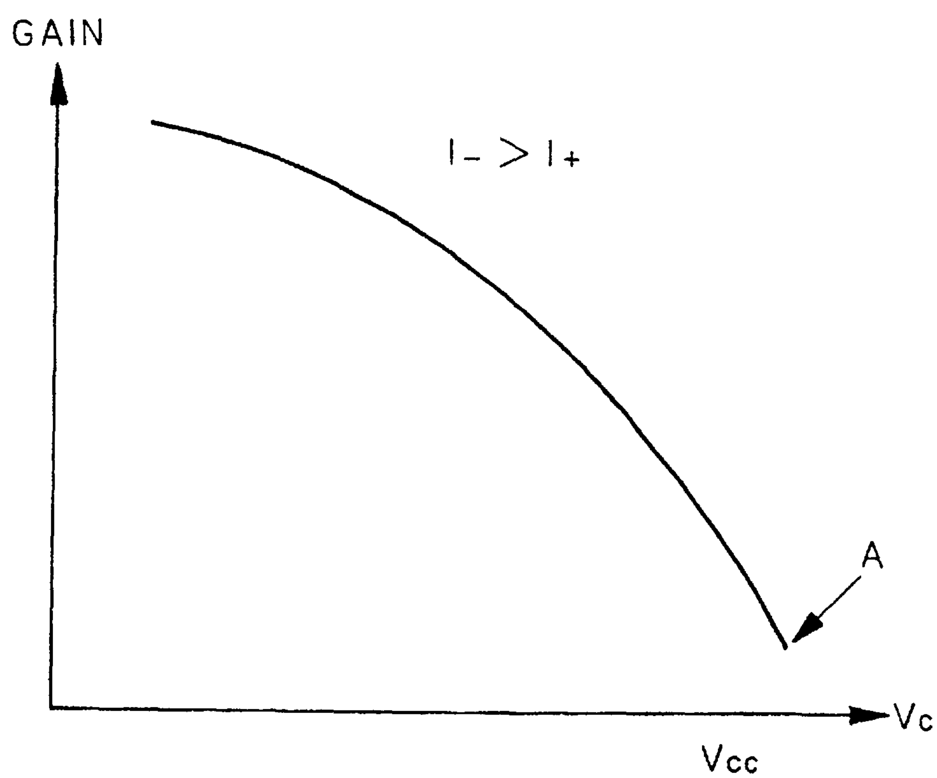

Fig. 5

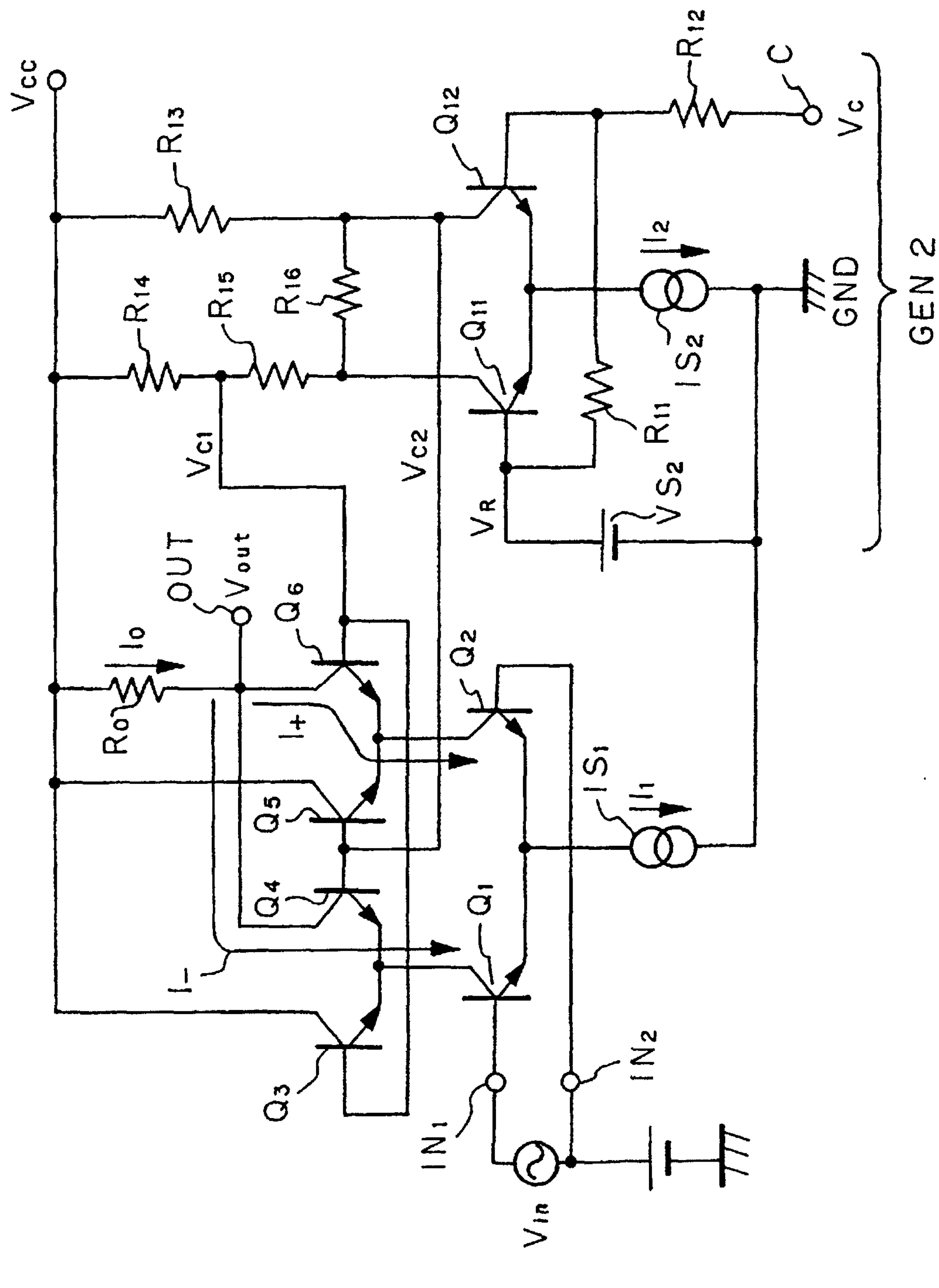
Vcc
R13
R14
R15
R16
Q12
Q11
R12
C
Vc
I2
IS2
GND
GEN 2
R11
VS2
VR
VC1
VC2
OUT
Vout
Q6
I0
R0
I+
Q2
Q5
IS1
I1
Q4
Q1
I−
Q3
IN1
IN2
Vin

Fig. 6

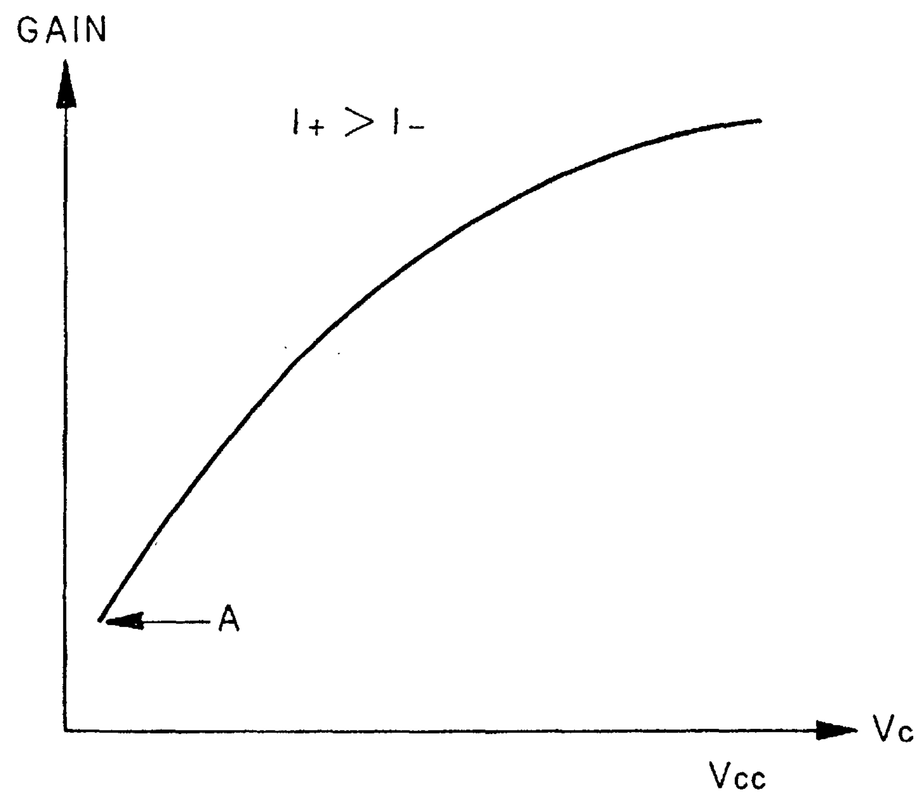

Fig. 7

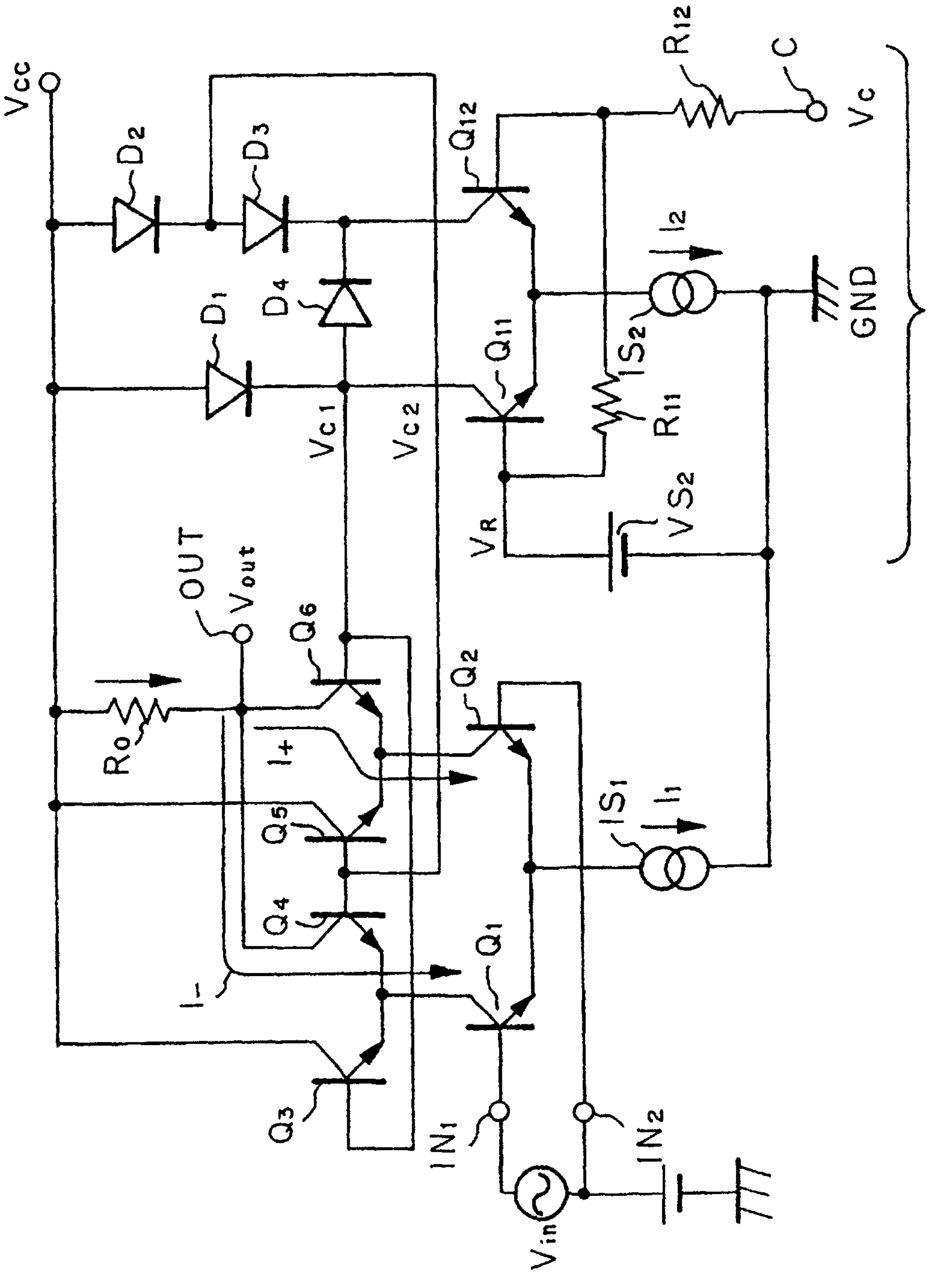
Vcc
D2
D3
D1
D4
Q12
Q11
R12
C
Vc
I2
IS2
R11
GND
GEN 1
Vc1
Vc2
VR
VS2
OUT
Vout
Q6
Q2
Ro
I+
Q5
IS1
I1
Q4
Q1
I-
Q3
IN1
IN2
Vin

*Fig. 8*

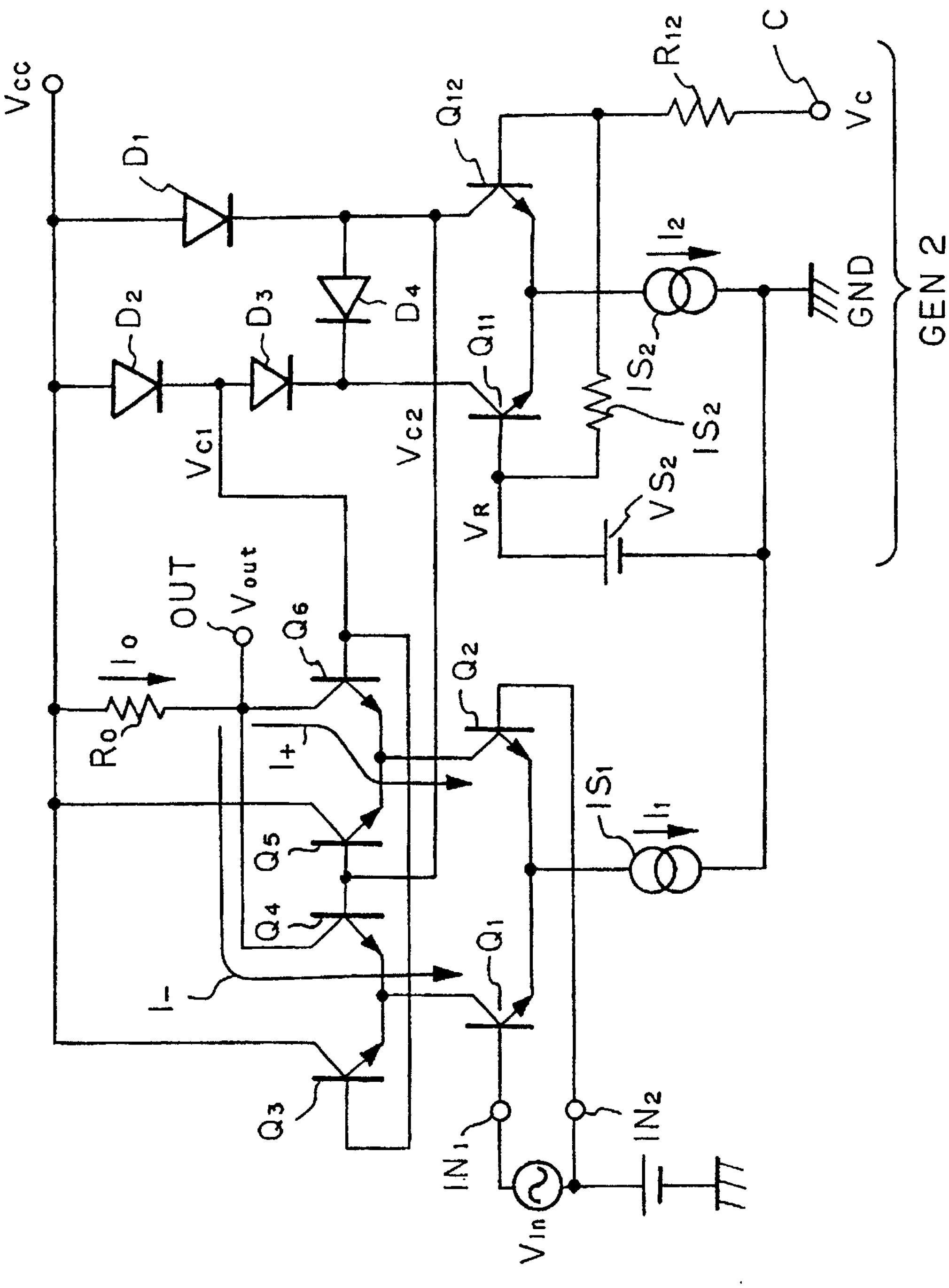
$V_{cc}$
$D_1$
$D_2$
$D_3$
$D_4$
$Q_{12}$
$R_{12}$
C
$V_c$
$Q_{11}$
$IS_2$
$I_2$
GND
GEN 2
$VS_2$
$V_R$
$V_{c1}$
$V_{c2}$
OUT
$V_{out}$
$Q_6$
$Q_2$
$I_0$
$R_0$
$I_+$
$Q_5$
$Q_4$
$Q_1$
$IS_1$
$I_1$
$I_-$
$Q_3$
$IN_1$
$IN_2$
$V_{in}$